# EUROPEAN PATENT SPECIFICATION

(11) **EP 3 748 693 B1**
(45) Date of publication and mention of the grant of the patent: **12.06.2024**
(21) Application number: 19756582.3
(22) Date of filing: 19.02.2019
(51) Int. Cl.: H01L 31/0224, H01L 31/068

(54) **SOLAR CELL AND ELECTRONIC DEVICE PROVIDED WITH SAID SOLAR CELL**
SOLARZELLE UND MIT BESAGTER SOLARZELLE AUSGESTATTETE ELEKTRONISCHE VORRICHTUNG
CELLULE SOLAIRE ET DISPOSITIF ÉLECTRONIQUE MUNI DE LADITE CELLULE SOLAIRE

(30) Priority: 23.02.2018 JP 2018031276
(43) Date of publication of application: 09.12.2020
(73) Proprietor: KANEKA CORPORATION, Osaka 530-8288 (JP)
(72) Inventor: UZU, Hisashi, Settsu-shi, Osaka 566-0072 (JP)
(74) Representative: V.O.
(86) International application number: PCT/JP2019/006043
(87) International publication number: WO 2019/163750

(56) References cited:
- EP-A2- 2 261 994
- WO-A1-2016/199501
- WO-A1-2017/093527
- JP-A- 2002 530 894
- JP-A- 2009 283 940
- US-A1- 2014 166 102
- US-A1- 2014 318 614

## Description

### TECHNICAL FIELD

The present invention relates to a back electrode type (back contact type) (also called back junction type) solar cell and an electronic device including the solar cell.

### BACKGROUND ART

Examples of a solar cell using a semiconductor substrate include a double-sided electrode type solar cell having electrodes formed on both surfaces of a light reception surface and a back surface, and a back electrode type solar cell having electrodes formed only on the back surface. Since such a double-sided electrode type solar cell has electrodes formed on the light reception surface, the electrodes shield sunlight. On the other hand, such a back electrode type solar cell has no electrodes formed on the light reception surface, and thus such a back electrode type solar cell has higher efficiency in receiving sunlight as compared with a double-sided electrode type solar cell. Patent Document 1 discloses a back electrode type solar cell.

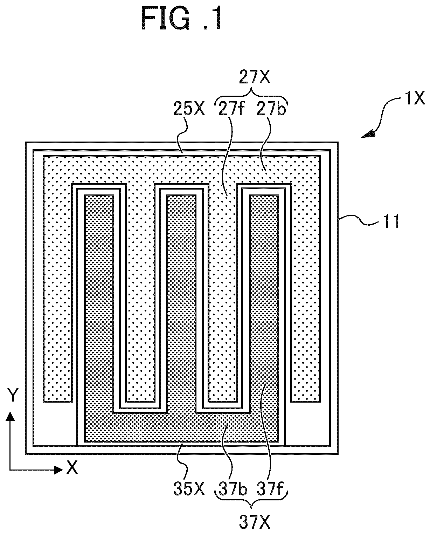

FIG. 1 shows such a conventional back electrode type solar cell as viewed from a back surface side. A solar cell 1X shown in FIG. 1 includes a first conductivity type semiconductor layer 25X and a second conductivity type semiconductor layer 35X formed on a back surface of a semiconductor substrate 11. The first conductivity type semiconductor layer 25X has a so-called comb shape with a plurality of finger parts corresponding to comb teeth and a bus bar part corresponding to a supporting part of the comb teeth. The bus bar part extends in an X direction along one peripheral portion of the semiconductor substrate 11. The finger parts extend from the bus bar part in a Y direction intersecting the X direction. Similarly, the second conductivity type semiconductor layer 35X has a so-called comb shape with a plurality of finger parts corresponding to comb teeth and a bus bar part corresponding to a supporting part of the comb teeth. The bus bar part extends in the X direction along the other peripheral portion facing a peripheral portion of the semiconductor substrate 11. The finger parts extend from the bus bar part in the Y direction. The finger parts of the first conductivity type semiconductor layer 25X and the finger parts of the second conductivity type semiconductor layer 35X are arranged alternately in the X direction. In this way, a forming region of the first conductivity type semiconductor layer 25X and a forming region of the second conductivity type semiconductor layer 35X are in meshing engagement with each other. This structure allows photocarriers induced in the semiconductor substrate 11 in response to incident light from a light reception surface to be collected efficiently at each of the semiconductor layers.

A first electrode layer 27X and a second electrode layer 37X for extracting the collected photocarriers to the outside are provided on the first conductivity type semiconductor layer 25X and the second conductivity type semiconductor layer 35X respectively. The first electrode layer 27X has a so-called comb shape with a plurality of finger parts 27f corresponding to comb teeth and a bus bar part 27b corresponding to a supporting part of the comb teeth. The bus bar part 27b extends in the X direction along one peripheral portion of the semiconductor substrate 11. The finger parts 27f extend from the bus bar part 27b in the Y direction intersecting the X direction. Similarly, the second electrode layer 37X has a so-called comb shape with a plurality of finger parts 37f corresponding to comb teeth and a bus bar part 37b corresponding to a supporting part of the comb teeth. The bus bar part 37b extends in the X direction along the other peripheral portion facing a peripheral portion of the semiconductor substrate 11. The finger parts 37f extend from the bus bar part 37b in the Y direction. The finger parts 27f and the finger parts 37f are arranged alternately in the X direction (see Patent Document 1, for example).

Patent Document 1: Japanese Unexamined Patent Application, Publication No. 2009-200267

Document WO 2017/093527A1 describes an arrangement of a solar cell on an interconnection layer.

### DISCLOSURE OF THE INVENTION

### Problems to be Solved by the Invention

Products of high design quality are required as electronic devices such as wearable devices or wristwatches, and products having a variety of shapes are expected to be designed. Hence, a variety of shapes conforming to the shapes of electronic devices are also considered to be required for products of solar cells to be installed on such electronic devices. In electronic devices such as wearable devices or wristwatches, for example, need is expected to be increased for a solar cell having a specific region such as a viewing window at a display part provided at a lower position of a solar cell or a through hole of a hand axis of a wristwatch, for example.

Regarding the conventional back electrode type solar cell 1X shown in FIG. 1, however, formation of a specific region such as a through hole, for example, may separate the finger parts 27f of the first electrode layer 27X. This makes it difficult to extract carriers collected at the first electrode layer 27X, namely, to extract the output of the solar cell 1X.

The present invention is intended to provide a solar cell that facilitates extraction of output even if the solar cell has a specific region, and an electronic device including the solar cell.

### Means for Solving the Problems

A solar cell according to the present invention is defined in claim 1.

An electronic device according to the present invention includes the solar cell described above.

### Effects of the Invention

According to the present invention, a solar cell that facilitates extraction of output even if the solar cell has a specific region, and an electronic device including the solar cell can be provided.

### BRIEF DESCRIPTION OF THE DRAWINGS

FIG. 1 shows a conventional solar cell as viewed from a back surface side;
FIG. 2 shows a solar cell according to the present embodiment as viewed from a back surface side;
FIG. 3 is a cross-sectional view taken along a line III-III in the solar cell shown in FIG. 2;
FIG. 4 shows a solar cell according to a first modification of the present embodiment as viewed from a back surface side;
FIG. 5 shows a solar cell according to a second modification of the present embodiment as viewed from a back surface side;
FIG. 6 shows a solar cell according to a third modification of the present embodiment as viewed from a back surface side; and
FIG. 7 shows a solar cell according to a fourth modification of the present embodiment as viewed from a back surface side.

### PREFERRED MODE FOR CARRYING OUT THE INVENTION

Examples of an embodiment according to the present invention will be described below by referring to the accompanying drawings. It is noted that, in the drawings, the same or corresponding parts are denoted by the same reference numerals. For the sake of convenience, hatching, member reference numerals, etc. may be omitted. However, in such cases, other drawings shall be referred to.

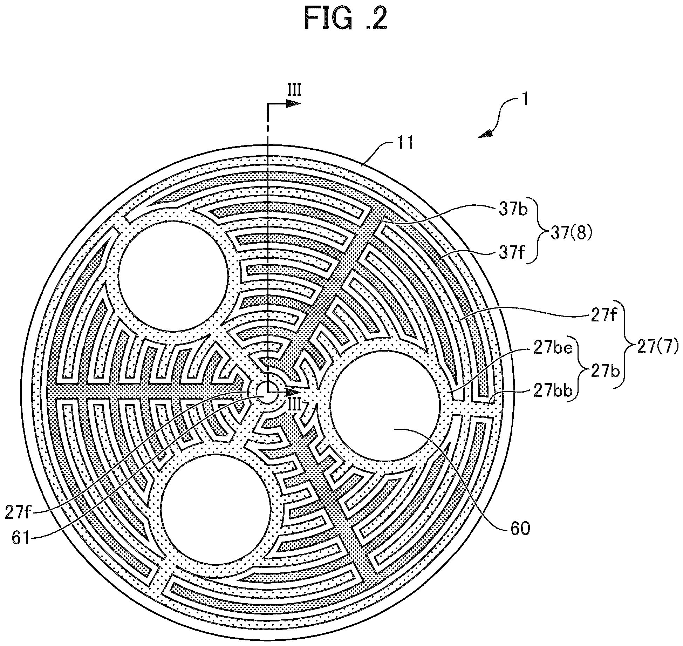

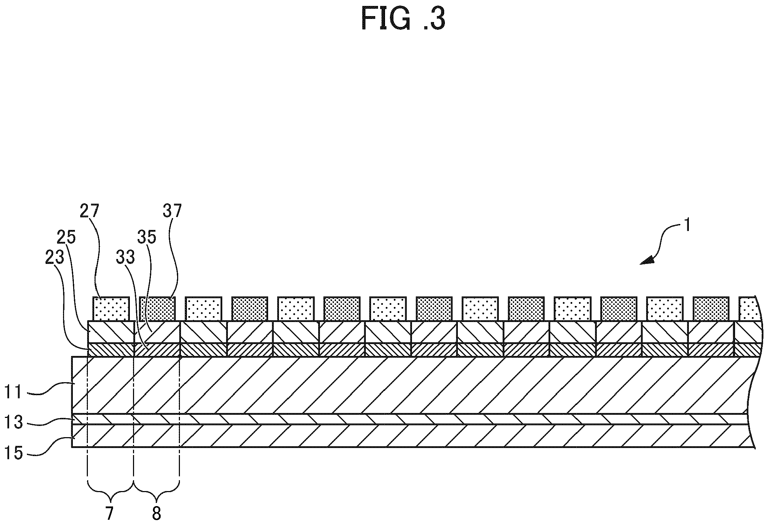

FIG. 2 shows a solar cell according to the present embodiment, not part of the invention, as viewed from a back surface side. FIG. 3 is a cross-sectional view taken along a line III-III in the solar cell shown in FIG. 2. As shown in FIGS. 2 and 3, a solar cell 1 is a back electrode type (back junction type) solar cell. The solar cell 1 includes a semiconductor substrate 11 having two major surfaces, and includes a first conductivity type region 7 and a second conductivity type region 8 at the major surfaces of the semiconductor substrate 11.

The solar cell 1 includes a passivation layer 13 and an anti-reflective layer 15 sequentially laminated at a major surface on a light reception side that is one of the two major surfaces of the semiconductor substrate 11. The solar cell 1 further includes a passivation layer 23, a first conductivity type semiconductor layer 25, and a first electrode layer 27 sequentially laminated in the first conductivity type region 7 at a back surface corresponding to the other of the major surfaces of the semiconductor substrate 11 on the opposite side of the light reception surface. The solar cell 1 further includes a passivation layer 33, a second conductivity type semiconductor layer 35, and a second electrode layer 37 sequentially laminated in the second conductivity type region 8 at the back surface of the semiconductor substrate 11.

### <Semiconductor substrate>

A conductive single crystal silicon substrate, for example, an n-type single crystal silicon substrate or a p-type single crystal silicon substrate, is used as the semiconductor substrate 11. This achieves high photoelectric conversion efficiency. The semiconductor substrate 11 is preferably an n-type single crystal silicon substrate. In an n-type single crystalline silicon substrate, a carrier lifetime is longer. This is because, in a p-type single crystal silicon substrate, light induced degradation (LID) may occur, in which light irradiation affects boron (B), which is a p-type dopant, and thereby a carrier becomes a recombination center. On the other hand, in an n-type single crystal silicon substrate, LID is further suppressed from occurring.

The semiconductor substrate 11 may have a fine uneven structure of a pyramidal shape called a texture structure provided on the back surface that is one of the two major surfaces. This increases efficiency in collecting light having passed through the semiconductor substrate 11 without being absorbed in the semiconductor substrate 11. The semiconductor substrate 11 may have a fine uneven structure of a pyramidal shape called a texture structure provided on the light reception surface. This reduces reflection of incident light on the light reception surface to improve the optical confinement effect in the semiconductor substrate 11.

The thickness of the semiconductor substrate 11 is preferably between 50 and 200 pm inclusive, more preferably between 60 and 180 pm inclusive, and still more preferably between 70 and 180 pm inclusive. Forming the semiconductor substrate 11 into such a small thickness achieves an increase in open-circuit voltage and a reduction in the cost of materials of the solar cell 1. It is noted that, as the semiconductor substrate 11, a conductive polycrystalline silicon substrate may be used, for example, an n-type polycrystalline silicon substrate or a p-type polycrystalline silicon substrate. In this case, a back electrode type solar cell is manufactured at lower costs.

### <Anti-reflective layer>

The anti-reflective layer 15 is formed on the light reception surface of the semiconductor substrate 11 via the passivation layer 13. The passivation layer 13 is formed as an intrinsic silicon-based layer. The passivation layer 13 functions to terminate surface defects of the semiconductor substrate 11 to suppress carrier recombination. A translucent film having a refractive index of approximately 1.5 to 2.3 inclusive is preferably used as the anti-reflective layer 15. As a material of the anti-reflective layer 15, SiO, SiN, or SiON is preferable, for example. While a method of forming the anti-reflective layer 15 is not particularly limited, a chemical vapor deposition (CVD) method achieving precise control of a film thickness is preferably used. Film formation by the CVD method achieves control of film quality by controlling material gas or conditions for the film formation.

In the present embodiment, the light reception surface has no electrodes formed thereon (back electrode type), and such a solar cell has high efficiency in receiving sunlight, and thus the photoelectric conversion efficiency thereof is high.

### <First conductivity type semiconductor layer and second conductivity type semiconductor layer>

The first conductivity type semiconductor layer 25 is formed in the first conductivity type region 7 at the back surface of the semiconductor substrate 11 via the passivation layer 23. The second conductivity type semiconductor layer 35 is formed in the second conductivity type region 8 at the back surface of the semiconductor substrate 11 via the passivation layer 33. The first conductivity type semiconductor layer 25 has a shape conforming to the shape of the first electrode layer 27 described later (see FIG. 2). The second conductivity type semiconductor layer 35 has a shape conforming to the shape of the second electrode layer 37 described later (see FIG. 2).

The first conductivity type semiconductor layer 25 is formed as a first conductivity type silicon-based layer, for example, a p-type silicon-based layer. The second conductivity type semiconductor layer 35 is formed as a silicon-based layer of a second conductivity type different from the first conductivity type, for example, an n-type silicon-based layer. The first conductivity type semiconductor layer 25 may be an n-type silicon-based layer, and the second conductivity type semiconductor layer 35 may be a p-type silicon-based layer. Each of the p-type silicon-based layer and the n-type silicon-based layer is formed of an amorphous silicon layer or a microcrystal silicon layer containing amorphous silicon and crystal silicon. Boron (B) is preferably used as dopant impurities in the p-type silicon-based layer. Phosphorus (P) is preferably used as dopant impurities in the n-type silicon-based layer.

While a method of forming the first conductivity type semiconductor layer 25 and the second conductivity type semiconductor layer 35 is not particularly limited, a CVD method is preferably used. As an example, SiH₄ gas is preferably used as a material gas. As an example, hydrogen-diluted B₂H₆ or PH₃ is preferably used as a dopant addition gas. A very small quantity of impurities of, for example, oxygen or carbon may be added in order to improve light transmittance. In this case, gas, for example, CO₂ or CH₄ is introduced during film formation by the CVD method. As a different exemplary method of forming the first conductivity type semiconductor layer 25 and the second conductivity type semiconductor layer 35, a thermal diffusion doping method or a laser doping method is used.

In the back electrode type solar cell, light is received on the light reception surface and generated carriers are collected at the back surface. For this reason, the first conductivity type semiconductor layer 25 and the second conductivity type semiconductor layer 35 are formed in the same plane. A method of forming (patterning) the first conductivity type semiconductor layer 25 and the second conductivity type semiconductor layer 35 into predetermined shapes in the same plane is not particularly limited. A CVD method using a mask may be employed. Alternatively, an etching method using a resist, an etching solution, or etching paste may be employed, for example.

Preferably, the first conductivity type semiconductor layer 25 and the second conductivity type semiconductor layer 35 are not joined. Thus, an insulating layer (not shown) may be provided between these layers. If an insulating layer is provided at a boundary between a p-type silicon-based thin film and an n-type silicon-based thin film, and if the insulating layer is made of silicon oxide, for example, and is formed by a CVD method, a film forming step can be simplified to encourage a reduction in process costs and improvement of yield.

### <Passivation layer>

The passivation layers 23 and 33 are each formed as an intrinsic silicon-based layer. The passivation layers 23 and 33 function to terminate surface defects of the semiconductor substrate 11 to suppress carrier recombination. This extends carrier lifetime to increase the output of the solar cell.

### <First electrode layer and second electrode layer>

The first electrode layer 27 is formed on the first conductivity type semiconductor layer 25. The second electrode layer 37 is formed on the second conductivity type semiconductor layer 35. The first electrode layer 27 and the second electrode layer 37 are isolated (are not connected directly electrically to each other).

The first electrode layer 27 and the second electrode layer 37 may be formed as transparent conductive layers made of a transparent conductive material. As the transparent conductive material, transparent conductive metal oxide is used, for example, indium oxide, tin oxide, zinc oxide, titanium oxide, and complex oxides thereof. From among these, an indium-based complex oxide mainly containing indium oxide is preferably used. An oxide of indium is particularly preferably used, from a viewpoint of high conductivity and transparency. Furthermore, it is preferable to add dopant to an oxide of indium in order to ensure reliability or higher conductivity. Examples of the dopant include Sn, W, Zn, Ti, Ce, Zr, Mo, Al, Ga, Ge, As, Si and S. A method used for forming these transparent electrode layers is a physical vapor deposition method such as a sputtering method or a chemical vapor deposition method (CVD method, for example) using a reaction of an organometallic compound with oxygen or water, for example.

The first electrode layer 27 and the second electrode layer 37 are not limited to the transparent electrode layers but they may include metal electrode layers laminated on the transparent electrode layers. Namely, the first electrode layer and the second electrode layer may be a laminated first electrode layer and a laminated second electrode layer each composed of the laminated transparent electrode layer and metal electrode layer. One of the first electrode layer and the second electrode layer may be a laminated electrode layer and the other may be a single-layer transparent electrode layer. The metal electrode layers are made of a metal material. Examples of the metal material include Cu, Ag, Al, and an alloy of these materials. A printing method such as screen printing using Ag paste, for example, or a plating method such as electrolytic plating using Cu, for example, is employed as a method of forming the metal electrode layers. Each of the first electrode layer 27 and the second electrode layer 37 may be formed only of a metal electrode layer.

Preferably, the width of the first electrode layer 27 is smaller than that of the first conductivity type semiconductor layer 25, and the width of the second electrode layer 37 is smaller than that of the second conductivity type semiconductor layer 35.

To efficiently extract photocarriers collected at the first conductivity type semiconductor layer 25 and the second conductivity type semiconductor layer 35, the first electrode layer 27 and the second electrode layer 37 preferably have largest possible widths relative to the first conductivity type semiconductor layer 25 and the second conductivity type semiconductor layer 35 respectively. Thus, the width of the first electrode layer 27 is preferably greater than 0.5 times, more preferably, greater than 0.7 times the width of the first conductivity type semiconductor layer 25. Likewise, the width of the second electrode layer 37 is preferably greater than 0.5 times, more preferably, greater than 0.7 times the width of the second conductivity type semiconductor layer 35. If an insulating layer or another layer is provided at a boundary between the first conductivity type semiconductor layer 25 and the second conductivity type semiconductor layer 35 so the first electrode layer 27 and the second electrode layer 37 are isolated from each other, the width of the first electrode layer 27 may be greater than that of the first conductivity type semiconductor layer 25, and the width of the second electrode layer 37 may be greater than that of the second conductivity type semiconductor layer 35.

On the other hand, to efficiently collect photocarriers in the semiconductor substrate 11 using the first conductivity type semiconductor layer 25 and the second conductivity type semiconductor layer 35, the respective widths of the first electrode layer 27 (first branch electrode layer 27f and first trunk electrode layer 27b described later) and the second electrode layer 37 (second branch electrode layer 37f and second trunk electrode layer 37b described later) preferably have some certain degree of smallness. While the respective widths of the first branch electrode layer 27f and the second branch electrode layer 37f, and those of the first conductivity type semiconductor layer 25 and the second conductivity type semiconductor layer 35 corresponding to the respective branch electrodes are not particularly limited as long as they have some certain degree of smallness, these widths are preferably in a range between 50 and 3000 pm inclusive. Unless otherwise specified, the widths of a conductive layer and an electrode layer are defined in directions orthogonal to directions of their extensions. On the other hand, from a viewpoint of electricity transport, a trunk electrode layer requires a certain degree of cross-sectional area for reducing electrical resistance loss, and the cross-sectional area is required to be ensured using the width and height of the trunk electrode layer. In this regard, the respective widths of the first trunk electrode layer 27b and the second trunk electrode layer 37b, and those of the first conductivity type semiconductor layer 25 and the second conductivity type semiconductor layer 35 corresponding to the respective trunk electrode layers are preferably in a range between 50 and 5000 pm inclusive.

Increasing the respective heights of the first electrode layer 27 and the second electrode layer 37 increases a cross-sectional area for a current to flow in a plane direction, thereby reducing series resistance. However, increasing the height of an electrode layer increases stress at an interface between a semiconductor layer and the electrode layer, and this may cause detachment of an electrode. Moreover, in a back electrode type solar cell in which an electrode is provided only on one surface, increasing the height of an electrode layer causes a stress unbalance between the front and back of a substrate. In this case, deformation such as deflection of the solar cell is likely to occur, and this may cause breakage of the solar cell. If the solar cell is deformed by stress at an electrode interface, trouble such as misalignment or short-circuit may occur during configuration of the solar cell as a module. For this reason, the respective heights of the first electrode layer 27 and the second electrode layer 37 are preferably equal to or less than 100 pm, more preferably equal to or less than 60 pm, and still more preferably, equal to or less than 30 pm. The height of an electrode is a distance from a major surface of a substrate to the top of the electrode. In the presence of a region of the substrate where a thickness is reduced partially by etching for forming a semiconductor layer, for example, a reference plane parallel to the major surface of the substrate may be defined, and a distance from the reference plane to the top of the electrode may be defined as the height of the electrode.

### <First specific region and second specific region>

In the solar cell 1, one or a plurality of first specific regions 60 and one or a plurality of second specific regions 61 are formed at a major surface of the semiconductor substrate 11. In the solar cell 1 according to the present embodiment shown in FIG. 2, three first specific regions 60 and one second specific region 61 are formed. The first specific region 60 and the second specific region 61 are regions not including the first electrode layer 27 and the second electrode layer 37. The first specific region 60 and the second specific region 61 may include the passivation layer 23 and the first conductivity type semiconductor layer 25, and the passivation layer 33 and the second conductivity type semiconductor layer 35. In an electronic device such as a wearable device or a wristwatch, for example, the first specific region 60 is a through hole for a viewing window at a display part provided at a lower position of the solar cell, and the second specific region 61 is a through hole for a hand axis of a wristwatch. Alternatively, the first specific region 60 and the second specific region 61 may be regions provided at the semiconductor substrate 11 and having a material of higher resistance than the first electrode layer 27 and the second electrode layer 37.

The first specific region 60 and the second specific region 61 have circular shapes, for example, in a plan view of the major surface of the semiconductor substrate 11. However, this is not the only shape of the first specific region 60 and the second specific region 61 but the first specific region 60 and the second specific region 61 may have a strip shape or a polygonal shape (a triangular shape or a rectangular shape, for example). A plurality of the first specific regions 60 and a plurality of the second specific regions 61, or one first specific region 60 and one second specific region 61 may be formed in the semiconductor substrate 11. In the presence of a plurality of the first specific regions 60, these first specific regions 60 may have the same area or different areas. In the presence of a plurality of the second specific regions 61, these second specific regions 61 may have the same area or different areas. The first specific region 60 and the second specific region 61 may have the same area or different areas.

The first specific region 60 has an outer edge enclosed by the first enclosing trunk electrode layer 27be (or second enclosing trunk electrode layer 37be) of the first electrode layer 27 (or second electrode layer 37) described later. The second specific region 61 has an outer edge enclosed by the first branch electrode layer 27f (or second branch electrode layer 37f) of the first electrode layer 27 (or second electrode layer 37) described later.

### <Details of first electrode layer and second electrode layer>

The first electrode layer 27 and the second electrode layer 37 are preferably formed to be distributed in all regions in the major surface of the semiconductor substrate 11 except the first specific region 60 and the second specific region 61. This increases an effective power generation area to increase photoelectric conversion efficiency. The first electrode layer 27 includes a plurality of first branch electrode layers 27f and three first trunk electrode layers 27b. The second electrode layer 37 includes a plurality of second branch electrode layers 37f and three second trunk electrode layers 37b.

### <<First branch electrode layer and second branch electrode layer>>

The first branch electrode layer 27f and the second branch electrode layer 37f are so-called finger electrodes and have shapes like strips (strip shapes). The first branch electrode layer 27f and the second branch electrode layer 37f may have linear shapes or curved shapes. Electrode patterns of the first branch electrode layer 27f and the second branch electrode layer 37f are not particularly limited. In a region except regions for forming the first specific region 60, the second specific region 61, the first trunk electrode layer 27b, and the second trunk electrode layer 37b, each of the first branch electrode layer 27f and the second branch electrode layer 37f preferably has a pattern concentric with the semiconductor substrate 11, for example. In other words, each of the first branch electrode layer 27f and the second branch electrode layer 37f is preferably formed to be centered on the center of the semiconductor substrate 11 and to overlap a similar figure of the semiconductor substrate 11. By doing so, the first branch electrode layer 27f and the second branch electrode layer 37f are distributed tightly across the entire region of the semiconductor substrate 11, and become unlikely to be separated at the periphery of the semiconductor substrate 11. With these shapes of the branch electrode layers, even if deflection occurs at the semiconductor substrate 11 in response to formation of the branch electrode layers, this deflection occurs relatively uniformly across the entire substrate, thereby reducing the occurrence of locally large deflection. In this way, the occurrence of breakage, etc. of the solar cell is reduced.

In terms of a local range, it is preferable that the first branch electrode layer 27f and the second branch electrode layer 37f be locally aligned in parallel by being arranged alternately in a direction vertical to a direction in which the first branch electrode layer 27f and the second branch electrode layer 37f extend (a direction vertical to a tangent to each point, for example).

In a range between the first trunk electrode layer 27b and the second trunk electrode layer 37b adjacent to each other, one end of the first branch electrode layer 27f is connected to the first trunk electrode layer 27b and the other end of the first branch electrode layer 27f is isolated from the second trunk electrode layer 37b. Further, one end of the second branch electrode layer 37f is connected to the second trunk electrode layer 37b and the other end of the second branch electrode layer 37f is isolated from the first trunk electrode layer 27b.

The first branch electrode layers 27f include a first branch electrode layer 27f closest to the center of the semiconductor substrate 11 and enclosing the outer edge of the second specific region 61. This first branch electrode layer 27f may have an annular shape (closed ring-like shape) or an open ring-like shape.

### <<First trunk electrode layer>>

The first trunk electrode layer 27b is a so-called bus bar electrode, and has a shape like a strip (strip shape) or a complicated shape formed by winding a strip shape or coupling strip shapes. The first trunk electrode layer 27b may have a linear shape or a curved shape. The first trunk electrode layer 27b includes a first enclosing trunk electrode layer 27be and a first strip trunk electrode layer 27bb.

### <<<First enclosing trunk electrode layer>>>

The first enclosing trunk electrode layer 27be is formed to enclose the outer edge of the first specific region 60. The first enclosing trunk electrode layer 27be may have an annular shape (closed ring-like shape) or an open ring-like shape. The first enclosing trunk electrode layer 27be may have a curved shape or a linear shape. Alternatively, the first enclosing trunk electrode layer 27be may have a circular shape or a polygonal shape.

### <<<First strip trunk electrode layer>>>

The first strip trunk electrode layer 27bb has a shape extending in a strip shape from the first enclosing trunk electrode layer 27be in a radial direction from the center toward the outer edge of the semiconductor substrate 11, in other words, in a radial direction from the center of concentric circles of the first branch electrode layers 27f. In this way, the first strip trunk electrode layer 27bb extends from the first enclosing trunk electrode layer 27be in such a manner as to intersect the first branch electrode layers 27f as concentric circles. The first strip trunk electrode layer 27bb may have a linear shape or a curved shape. A plurality of the first branch electrode layers 27f is connected to the first enclosing trunk electrode layer 27be and the first strip trunk electrode layer 27bb. This prevents disconnection of the branch electrode layer caused by the first specific region 60 such as a through hole or a high-resistance region, for example, thereby preventing the first branch electrode layer 27f from being unconnected to the first trunk electrode layer 27b and thus being isolated electrically. In this way, carriers collected at a plurality of the first branch electrode layers 27f are collected via the first trunk electrode layer 27b (first enclosing trunk electrode layer 27be, first strip trunk electrode layer 27bb), namely, the output of the solar cell 1 is increased.

### <<Second trunk electrode layer>>

The second trunk electrode layer 37b is a so-called bus bar electrode, and has a strip shape extending in the radial direction at the semiconductor substrate 11. The second trunk electrode layer 37b may have a linear shape or a curved shape. The second trunk electrode layer 37b is arranged between the first trunk electrode layers 27b adjacent to each other. A plurality of the second branch electrode layers 37f are connected to the second trunk electrode layer 37b. This prevents the second branch electrode layer 37f from being unconnected to the second trunk electrode layer 37b and thus being isolated electrically. In this way, carriers collected at a plurality of the second branch electrode layers 37f are collected via the second trunk electrode layer 37b, namely, the output of the solar cell 1 is increased.

As described above, the first trunk electrode layer 27b and the second trunk electrode layer 37b are used for reliably collecting carriers collected at a plurality of the first branch electrode layers 27f and a plurality of the second branch electrode layers 37f in the entire region of the solar cell 1, thereby increasing the output of the solar cell 1.

The back electrode type solar cell according to the present embodiment is preferably employed in an electronic device mainly used in a low-illuminance environment, particularly for wearable purposes (a wristwatch, a smart watch, or a sensor), etc. In this case, the intensity of light generally emitted is low and electrical resistance loss is not serious compared to that in a solar cell panel. For this reason, forming an extraction electrode and an extraction electrode functioning as an anode and a cathode (not shown) at a part of a corresponding one of the first trunk electrode layer 27b and the second trunk electrode layer 37b facilitates extraction of collected carriers. The extraction electrodes are formed by a method that may be a printing method such as screen printing using Ag paste, for example, or a plating method such as electrolytic plating using Cu, for example. Alternatively, the extraction electrodes may be formed by soldering, for example.

### (First modification)

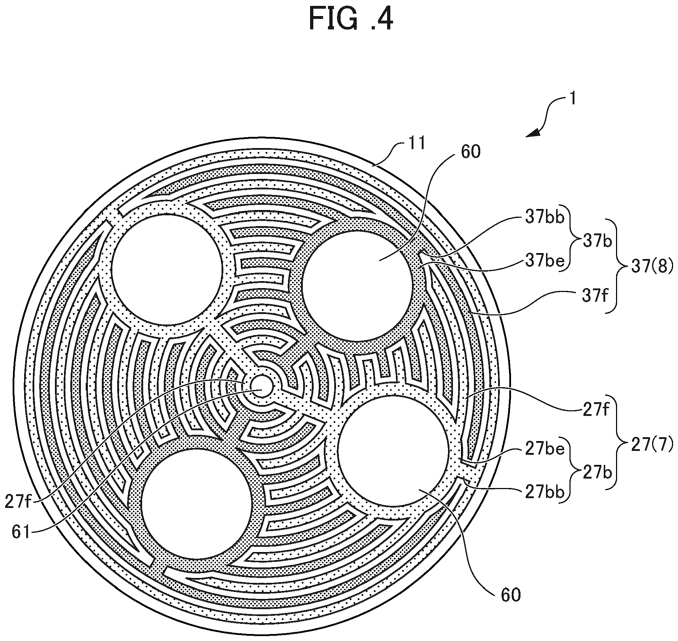

FIG. 4 shows a solar cell according to the invention and according to a first modification of the present embodiment as viewed from a back surface side. A solar cell 1 shown in FIG. 4 differs from the present embodiment in that in the solar cell 1 shown in FIG. 2, the second trunk electrode layer 37b of the second electrode layer 37 includes a second enclosing trunk electrode layer 37be and a second strip trunk electrode layer 37bb. The first enclosing trunk electrode layer 27be of the first trunk electrode layer 27b of the first electrode layer 27 is formed to enclose the outer edges of two of (a part of) the four first specific regions 60. The second enclosing trunk electrode layer 37be is formed to enclose the other two of (a part other than the above part of) the four first specific regions 60. In other words, the first enclosing trunk electrode layer 27be is formed to enclose the outer edges of two first specific regions 60 out of the first specific regions 60 and the second specific region 61. The second enclosing trunk electrode layer 37be is formed to enclose the outer edges of two first specific regions 60 out of the other first specific regions 60 and the second specific region 61 (there may be a specific region such as the second specific region 61 not enclosed by the first or second enclosing trunk electrode layer 27be or enclosing trunk electrode layer 37be). The second enclosing trunk electrode layer 37be may have an annular shape (closed ring-like shape) or an open ring-like shape. The second enclosing trunk electrode layer 37be may have a curved shape or a linear shape. Alternatively, the second enclosing trunk electrode layer 37be may have a circular shape or a polygonal shape. The second strip trunk electrode layer 37bb has a shape extending in a strip shape from the second enclosing trunk electrode layer 37be in a radial direction from the center toward the outer edge of the semiconductor substrate 11, in other words, in a radial direction from the center of concentric circles of the second branch electrode layers 37f. In this way, the second strip trunk electrode layer 37bb extends from the second enclosing trunk electrode layer 37be in such a manner as to intersect the second branch electrode layers 37f as concentric circles. The second strip trunk electrode layer 37bb may have a linear shape or a curved shape.

Two first trunk electrode layers 27b (first enclosing trunk electrode layers 27be and first strip trunk electrode layers 27bb) are arranged to face each other across the center and vicinity of the semiconductor substrate 11. Two second trunk electrode layers 37b (second enclosing trunk electrode layers 37be and second strip trunk electrode layers 37bb) are also arranged to face each other across the center and vicinity of the semiconductor substrate 11. Further, a direction in which the trunk electrode layers 27b face each other and a direction in which the trunk electrode layers 37b face each other intersect at the center and vicinity of the semiconductor substrate 11. By doing so, the first trunk electrode layer 27b and the second trunk electrode layer 37b are arranged adjacent to each other. Namely, the first trunk electrode layer 27b and the second trunk electrode layer 37b are aligned alternately in a pattern like a circle and are arranged adjacent to each other. Unlike in the case shown in FIG. 2, there is no need for providing the second trunk electrode layer 37b having a simple strip shape between the first enclosing trunk electrode layers 27be adjacent to each other and there are advantages in terms of the cost of materials, etc. For such an alternate arrangement of enclosing trunk electrode layers of different types, the number of the first specific regions 60 is preferably an even number. If the number of the first specific regions 60 is an odd number, enclosing trunk electrode layers of the same type are arranged adjacent to each other at least in one location. In this case, a trunk electrode of a different type is required to be arranged between these enclosing trunk electrode layers. Even in this case, the number of such trunk electrodes can be minimized to reduce the cost of materials.

### (Second modification)

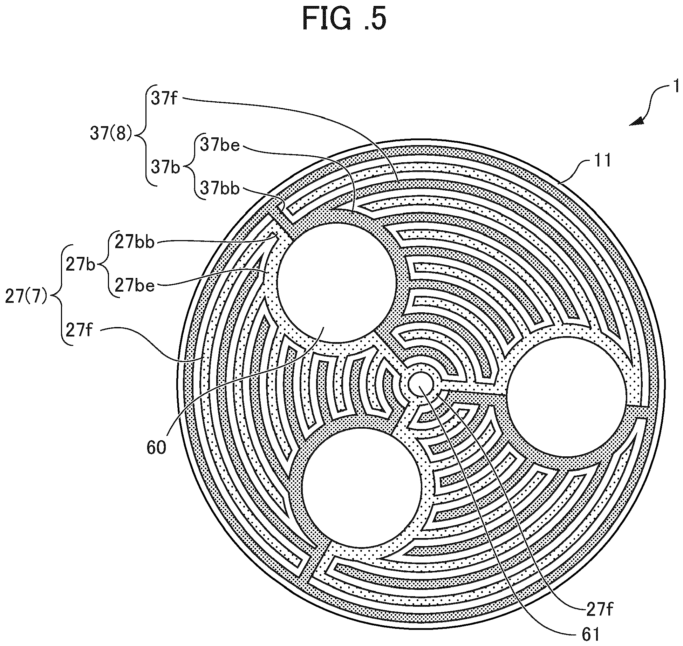

FIG. 5 shows a solar cell according to the invention and according to a second modification of the present embodiment as viewed from a back surface side. A solar cell 1 shown in FIG. 5 differs from the present embodiment in that in the solar cell 1 shown in FIG. 2, the outer edge of one first specific region 60 is enclosed both by the first enclosing trunk electrode layer 27be and the second enclosing trunk electrode layer 37be. The first enclosing trunk electrode layer 27be of the first electrode layer 27 encloses a half of (a part of) the outer edge of the first specific region 60. The second enclosing trunk electrode layer 37be of the second electrode layer 37 encloses the other half of (a part other than the above part of) the outer edge of the first specific region 60. The first strip trunk electrode layer 27bb of the first electrode layer 27 and the second strip trunk electrode layer 37bb of the second electrode layer 37 extend in adjacent positions. Unlike in the case shown in FIG. 2, there is no need for providing the second trunk electrode layer 37b having a simple strip shape between the first enclosing trunk electrode layers 27be (which are adjacent to each other), and there are advantages in terms of the cost of materials, etc. Additionally, even in the presence of the first specific regions 60 of an odd number like in the case of FIG. 5, the need for providing a trunk electrode between adjacent enclosing trunk electrodes is eliminated by forming opposing edges of the adjacent enclosing trunk electrodes into different types. This achieves an advantage in terms of the cost of materials, etc.

If the enclosing trunk electrode layer around the first specific region 60 is of one type like in the case of FIG. 2, currents from the branch electrode layers connected to the enclosing trunk electrode layer across the entire periphery flow into the trunk electrode layer. On the other hand, in a case such as the second modification shown in FIG. 5, the first enclosing trunk electrode layer 27be and the second enclosing trunk electrode layer 37be share the entire periphery of the first specific region 60. As a result, in the presence of similar specific regions (of an even number, for example) in the semiconductor substrate 11, the total currents flowing in the first trunk electrode layers 27b and the second trunk electrode layers 37b of the second modification become comparable to the currents flowing in the branch electrode layers connected to the enclosing trunk electrode layer of the first modification. Thus, from a viewpoint of resistance loss, the amount of material can be substantially equal between the metal material to be used for the trunk electrode layer in the first modification, and the total metal material to be used for the first trunk electrode layer 27b and the metal material to be used for the second trunk electrode layer 37b in the second modification. Even if the number of trunk electrodes is doubled in the second modification as a result of the use of trunk electrodes of different types, substantially equal costs of materials can be maintained by reducing the line widths or heights of these trunk electrodes by half.

### (Third modification)

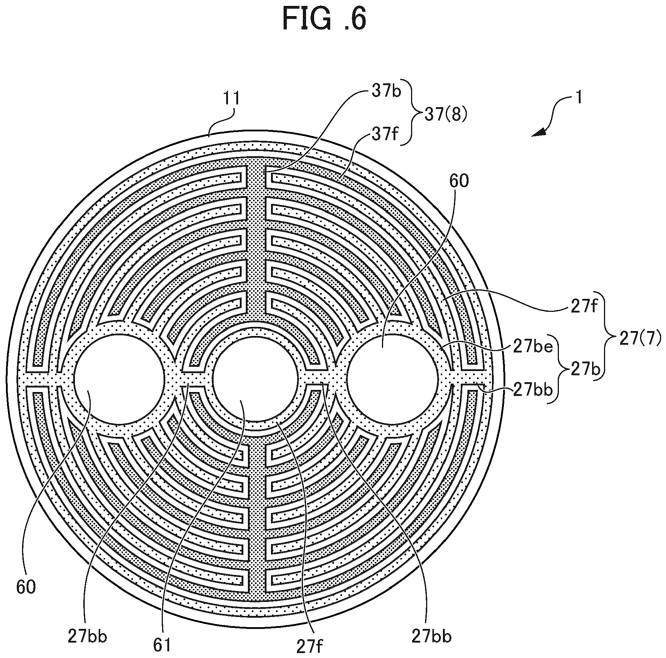

FIG. 6 shows a solar cell according to a third modification of the present embodiment, not part of the invention, as viewed from a back surface side. A solar cell 1 shown in FIG. 6 differs from the present embodiment in that in the solar cell 1 shown in FIG. 2, the first enclosing trunk electrode layers 27be are arranged in a line, for example. The second specific region 61 at the center differs from the first specific region 60 in that the second specific region 61 is enclosed by the first branch electrode layer 27f, not by an enclosing trunk electrode layer to which a plurality of branch electrodes are connected. The second specific region 61 at the center is formed at a position not separating a branch electrode and thus is not required to have an enclosing trunk electrode layer. On the other hand, this second specific region 61 can be formed only at a limited position relative to a branch electrode pattern. In terms of increasing the optionality of a solar cell design, not only providing a specific region at such a limited position but also providing a specific region at an optional position is required. For this reason, significance is given to the use of an enclosing trunk electrode layer.

### (Fourth modification)

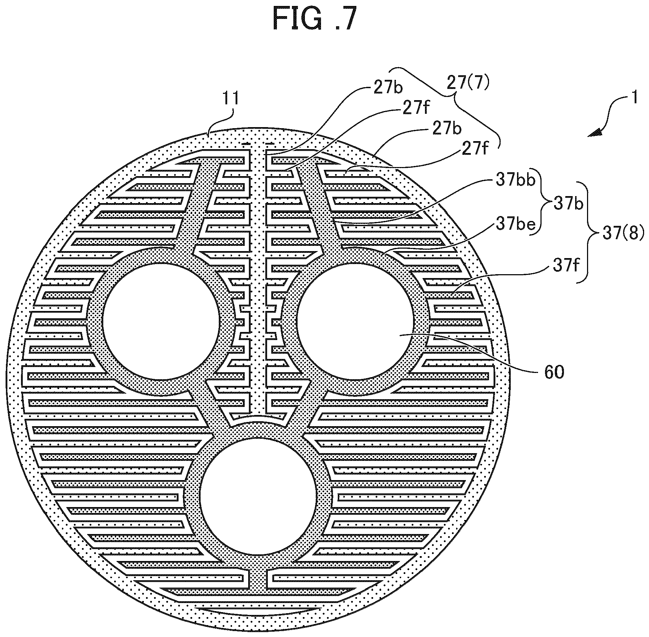

FIG. 7 shows a solar cell according to a fourth modification of the present embodiment, not part of the invention, as viewed from a back surface side. A solar cell 1 shown in FIG. 7 differs from the present embodiment in that the first trunk electrode layer 27b is provided along the periphery of the semiconductor substrate 11. Unlike those in the other drawings, in the example shown in FIG. 7, each of the first branch electrode layer 27f and the second branch electrode layer 37f has a shape completely different from a similar figure of the substrate. In this case, unlike in the case of FIG. 2 where each of the first branch electrode layer 27f and the second branch electrode layer 37f is formed to be centered on the center of the semiconductor substrate 11 and to overlap a similar figure of the semiconductor substrate 11, the first trunk electrode layer 27b is preferably provided along the periphery of the semiconductor substrate 11 for preventing separation of a branch electrode layer by the periphery of the semiconductor substrate 11. In this case, a strip trunk electrode layer may also extend from an enclosing trunk electrode layer in such a manner as to intersect branch electrode layers.

### (Electronic device)

For actual use of the solar cell 1 according to the present embodiment, the solar cell 1 is preferably configured as a module. The solar cell is configured as a module by an appropriate method. For example, a wire or a contact pin may be connected to the trunk electrode layers 27b and 37b functioning as an anode and a cathode or to extraction electrodes (not shown) at the corresponding electrode layers to allow extraction of electricity. A back electrode type solar cell is configured as a module by being sealed with a sealing agent and a glass plate. The solar cell configured as a module in this way becomes installable on an electronic device for wearable purposes (a wristwatch, a smart watch, or a sensor).

While the embodiment according to the present invention has been described so far, the present invention is not limited to the above-described embodiment, and various modifications are available. In the foregoing present embodiment, the heterojunction type solar cell has been described. In an example, the features of the present invention may be applied to various types of solar cells such as a homojunction type solar cell, and are not limited to such a heterojunction type solar cell.

The back electrode type solar cell 1 shown as an example in the present embodiment described above includes the passivation layer 23, the first conductivity type semiconductor layer 25, and the first electrode layer 27 sequentially laminated in the first conductivity type region 7 at the back surface of the semiconductor substrate 11, and the passivation layer 33, the second conductivity type semiconductor layer 35, and the second electrode layer 37 sequentially laminated in the second conductivity type region 8 at the back surface of the semiconductor substrate 11 excepting the first conductivity type region 7. However, the present invention is not limited to this solar cell 1 but may also be a back electrode type solar cell in which at least a part of a first conductivity type semiconductor layer and at least a part of a second conductivity type semiconductor layer overlap each other. This solar cell may be realized by forming the first electrode layer corresponding to the first conductivity type semiconductor layer using the first branch electrode layer and the first trunk electrode layer (first enclosing trunk electrode layer and/or first strip trunk electrode layer) described above, and by forming the second electrode layer corresponding to the second conductivity type semiconductor layer using the second branch electrode layer and the second trunk electrode layer (second enclosing trunk electrode layer and/or second strip trunk electrode layer) described above.

### EXPLANATION OF REFERENCE NUMERALS

1, 1X Solar cell
7 First conductivity type region
8 Second conductivity type region
11 Semiconductor substrate
13, 23, 33 Passivation layer
15 Anti-reflective layer
25, 25X First conductivity type semiconductor layer
27, 27X First electrode layer
27b First trunk electrode layer (bus bar electrode, bus bar part)
27bb First strip trunk electrode layer
27be First enclosing trunk electrode layer
27f First branch electrode layer (finger electrode, finger part)
35, 35X Second conductivity type semiconductor layer
37, 37X Second electrode layer
37b Second trunk electrode layer (bus bar electrode, bus bar part)
37bb Second strip trunk electrode layer
37be Second enclosing trunk electrode layer
37f Second branch electrode layer (finger electrode, finger part)
60 Through hole (first specific region)
61 Through hole (second specific region)

## Claims

1. A back electrode type solar cell (1) comprising a semiconductor substrate (11), a first conductivity type semiconductor layer (25) and a second conductivity type semiconductor layer (35) arranged on one of two major surfaces of the semiconductor substrate (11), a first electrode layer (27) corresponding to the first conductivity type semiconductor layer (25), and a second electrode layer (37) corresponding to the second conductivity type semiconductor layer (35), wherein
the solar cell (1) comprises a specific region (60) provided at the one major surface and not including the first electrode layer (27) and the second electrode layer (37),
each of the first electrode layer (27) and the second electrode layer (37) includes a plurality of strip branch electrode layers (27f, 37f) and a trunk electrode layer (27b, 37b) to which one end of each of the plurality of the strip branch electrode layers (27f, 37f) is connected, wherein the plurality of strip branch electrode layers (27f) of the first electrode layer (27) and the plurality of strip branch electrode layers (37f) of the second electrode layer (37) are interdigitated with each other, and
the trunk electrode layer (27b) of the first electrode layer (27) includes an enclosing trunk electrode layer (27be) enclosing an outer edge of the specific region (60) and a strip trunk electrode layer (27bb) extending from the enclosing trunk electrode layer (27be), wherein
in a first option the enclosing trunk electrode layer (27be) of the first electrode layer (27) encloses one part of the outer edge of the specific region (60), and an enclosing trunk electrode layer (37be) of the second electrode layer (37) encloses the part of the outer edge other than the one part of the specific region (60), and the strip trunk electrode layer (27bb) of the first electrode layer (27) and a strip trunk electrode layer (37bb) of the second electrode layer (37) are adjacent to each other;
or, in a second option, the solar cell (1) comprises a plurality of the specific regions (60), and wherein: each of the first electrode layer (27) and the second electrode layer (37) includes one or more of the trunk electrode layers (27b, 37b), the trunk electrode layer (37b) of the second electrode layer (37) includes an enclosing trunk electrode layer (37be) and a strip trunk electrode layer (37bb) extending from the enclosing trunk electrode layer (37be), each enclosing trunk electrode layer (27be) of the first electrode layer (27) encloses an outer edge of at least one specific region of a plurality of the specific regions (60), and each enclosing trunk electrode layer (37be) of the second electrode layer (37) encloses an outer edge of at least one specific region of the other of a plurality of the specific regions (60).

2. The solar cell (1) according to claim 1, comprising a plurality of the specific regions (60), wherein
the first electrode layer (27) includes a plurality of the trunk electrode layers (27b), and
the enclosing trunk electrode layers (27be) of a plurality of the trunk electrode layers (27b) enclose outer edges of a plurality of the specific regions (60).

3. The solar cell (1) according to the second option of claim 1, wherein the enclosing trunk electrode layer (27be) of the first electrode layer (27) is adjacent to the enclosing trunk electrode layer (37be) of the second electrode layer (37).

4. The solar cell (1) according to the second option of claim 1 or 2, wherein the trunk electrode layer (37b) of the second electrode layer (37) is arranged between adjacent ones of the trunk electrode layers (27b) of the first electrode layer (27).

5. The solar cell (1) according to any one of claims 1 to 4, wherein the enclosing trunk electrode layer (27be, 37be) has an annular shape or an open ring-like shape.

6. The solar cell (1) according to claim 5, wherein the enclosing trunk electrode layer (27be, 37be) has a curved shape.

7. The solar cell (1) according to any one of claims 1 to 6, wherein the strip trunk electrode layer (27bb, 37bb) has a curved shape or a linear shape.

8. The solar cell (1) according to any one of claims 1 to 7, wherein the branch electrode layer (27f, 37f) has a curved shape or a linear shape.

9. The solar cell (1) according to any one of claims 1 to 8, wherein the specific region (60) is a through hole or has a material of higher resistance than the first electrode layer (27) and the second electrode layer (37).

10. The solar cell (1) according to any one of the preceding claims, wherein a plurality of the specific regions (60) have the same area or different areas.

11. The solar cell (1) according to the second option of claim 1 or 2, wherein a plurality of the specific regions (60) are arranged in a line.

12. The solar cell (1) according to any one of claims 1 to 11, wherein in a region excepting the trunk electrode layer (27b, 37b) and the specific region (60), the branch electrode layer (27f, 37f) is formed to be centered on the center of the semiconductor substrate (11) and to overlap a similar figure of the semiconductor substrate (11).

13. An electronic device comprising the solar cell (1) according to any one of claims 1 to 12.

## Patentansprüche

1. Solarzelle mit rückseitiger Elektrode (1), umfassend ein Halbleitersubstrat (11), eine Halbleiterschicht (25) eines ersten Leitfähigkeitstyps und eine Halbleiterschicht (35) eines zweiten Leitfähigkeitstyps, die auf einer von zwei Hauptflächen des Halbleitersubstrats (11) angeordnet sind, eine erste Elektrodenschicht (27), die der Halbleiterschicht (25) des ersten Leitfähigkeitstyps entspricht, und eine zweite Elektrodenschicht (37), die der Halbleiterschicht (35) des zweiten Leitfähigkeitstyps entspricht, wobei
die Solarzelle (1) einen spezifischen Bereich (60) umfasst, der an der einen Hauptfläche bereitgestellt ist und die erste Elektrodenschicht (27) und die zweite Elektrodenschicht (37) nicht einschließt,
jede der ersten Elektrodenschicht (27) und der zweiten Elektrodenschicht (37) eine Vielzahl von Streifenzweig-Elektrodenschichten (27f, 37f) und eine Stammelektrodenschicht (27b, 37b) einschließt, mit der ein Ende jeder der Vielzahl der Streifenzweig-Elektrodenschichten (27f, 37f) verbunden ist, wobei die Vielzahl der Streifenzweig-Elektrodenschichten (27f) der ersten Elektrodenschicht (27) und die Vielzahl der Streifenzweig-Elektrodenschichten (37f) der zweiten Elektrodenschicht (37) miteinander verzahnt sind, und
die Stammelektrodenschicht (27b) der ersten Elektrodenschicht (27) eine umschließende Stammelektrodenschicht (27be) einschließt, die eine Außenkante des spezifischen Bereichs (60) umschließt, und eine Streifen-Stammelektrodenschicht (27bb), die sich von der umschließenden Stammelektrodenschicht (27be) erstreckt, wobei
in einer ersten Option die umschließende Stammelektrodenschicht (27be) der ersten Elektrodenschicht (27) einen Teil der Außenkante des spezifischen Bereichs (60) umschließt, und eine umschließende Stammelektrodenschicht (37be) der zweiten Elektrodenschicht (37) den Teil des äußeren Randes umschließt, der nicht der eine Teil des spezifischen Bereichs (60) ist, und die Streifen-Stammelektrodenschicht (27bb) der ersten Elektrodenschicht (27) und eine Streifen-Stammelektrodenschicht (37bb) der zweiten Elektrodenschicht (37) benachbart zueinander sind;
oder, in einer zweiten Option, die Solarzelle (1) eine Vielzahl der spezifischen Bereiche (60) umfasst, und wobei: jede der ersten Elektrodenschicht (27) und der zweiten Elektrodenschicht (37) eine oder mehrere der Stammelektrodenschichten (27b, 37b) einschließt, die Stammelektrodenschicht (37b) der zweiten Elektrodenschicht (37) eine umschließende Stammelektrodenschicht (37be) und eine Streifen-Stammelektrodenschicht (37bb) einschließt, die sich von der umschließenden Stammelektrodenschicht (37be) aus erstreckt, jede umschließende Stammelektrodenschicht (27be) der ersten Elektrodenschicht (27) eine Außenkante von mindestens einem spezifischen Bereich einer Vielzahl der spezifischen Bereiche (60) umschließt, und jede umschließende Stammelektrodenschicht (37be) der zweiten Elektrodenschicht (37) eine Außenkante von mindestens einem spezifischen Bereich des anderen einer Vielzahl der spezifischen Bereiche (60) umschließt.

2. Solarzelle (1) nach Anspruch 1, umfassend eine Vielzahl der spezifischen Bereiche (60), wobei
die erste Elektrodenschicht (27) eine Vielzahl der Stammelektrodenschichten (27b) einschließt, und
die umschließenden Stammelektrodenschichten (27be) einer Vielzahl der Rumpfelektrodenschichten (27b) Außenkanten einer Vielzahl der spezifischen Bereiche (60) umschließen.

3. Solarzelle (1) nach der zweiten Option von Anspruch 1, wobei die umschließende Stammelektrodenschicht (27be) der ersten Elektrodenschicht (27) benachbart zu der umschließenden Stammelektrodenschicht (37be) der zweiten Elektrodenschicht (37) ist.

4. Solarzelle (1) nach der zweiten Option von Anspruch 1 oder 2, wobei die Stammelektrodenschicht (37b) der zweiten Elektrodenschicht (37) zwischen benachbarten Stammelektrodenschichten (27b) der ersten Elektrodenschicht (27) angeordnet ist.

5. Solarzelle (1) nach einem der Ansprüche 1 bis 4, wobei die umschließende Stammelektrodenschicht (27be, 37be) eine ringförmige Form oder eine offene ringförmige Form aufweist.

6. Solarzelle (1) nach Anspruch 5, wobei die umschließende Stammelektrodenschicht (27be, 37be) eine gekrümmte Form aufweist.

7. Solarzelle (1) nach einem der Ansprüche 1 bis 6, wobei die Streifen-Stammelektrodenschicht (27bb, 37bb) eine gekrümmte Form oder eine lineare Form aufweist.

8. Solarzelle (1) nach einem der Ansprüche 1 bis 7, wobei die Zweigelektrodenschicht (27f, 37f) eine gekrümmte Form oder eine lineare Form aufweist.

9. Solarzelle (1) nach einem der Ansprüche 1 bis 8, wobei der spezifische Bereich (60) ein Durchgangsloch ist oder ein Material mit höherem Widerstand als die erste Elektrodenschicht (27) und die zweite Elektrodenschicht (37) aufweist.

10. Solarzelle (1) nach einem der vorstehenden Ansprüche, wobei eine Vielzahl der spezifischen Bereiche (60) die gleiche Fläche oder unterschiedliche Flächen aufweisen.

11. Solarzelle (1) nach der zweiten Option von Anspruch 1 oder 2, wobei eine Vielzahl der spezifischen Bereiche (60) in einer Linie angeordnet sind.

12. Solarzelle (1) nach einem der Ansprüche 1 bis 11, wobei in einem Bereich mit Ausnahme der Stammelektrodenschicht (27b, 37b) und des spezifischen Bereichs (60) die Zweigelektrodenschicht (27f, 37f) so gebildet ist, dass sie in der Mitte des Halbleitersubstrats (11) zentriert ist und eine ähnliche Figur des Halbleitersubstrats (11) überlappt.

13. Elektronische Vorrichtung, umfassend die Solarzelle (1) nach einem der Ansprüche 1 bis 12.

## Revendications

1. Cellule solaire de type électrode arrière (1) comprenant un substrat semi-conducteur (11), une couche semi-conductrice de premier type de conductivité (25) et une couche semi-conductrice de deuxième type de conductivité (35) agencées sur l'une de deux surfaces principales du substrat semi-conducteur (11), et une première couche d'électrode (27) correspondant à la couche semi-conductrice de premier type de conductivité (25), et une deuxième couche d'électrode (37) correspondant à la couche semi-conductrice de deuxième type de conductivité (35), dans laquelle
la cellule solaire (1) comprend une région spécifique (60) disposée au niveau de la surface principale et ne comportant pas la première couche d'électrode (27) ni la deuxième couche d'électrode (37),
chacune de la première couche d'électrode (27) et de la deuxième couche d'électrode (37) comporte une pluralité de couches d'électrode de dérivation en forme de bande (27f, 37f) et une couche d'électrode de jonction (27b, 37b) à laquelle une extrémité de chacune de la pluralité de couches d'électrode de dérivation en forme de bande (27f, 37f) est connectée, dans laquelle la pluralité de couches d'électrode de dérivation en forme de bande (27f) de la première couche d'électrode (27) et la pluralité de couches d'électrode de dérivation en forme de bande (37f) de la deuxième couche d'électrode (37) sont interdigitées les unes aux autres, et
la couche d'électrode de jonction (27b) de la première couche d'électrode (27) comporte une couche d'électrode de jonction enveloppante (27be) enveloppant un bord externe de la région spécifique (60) et une couche d'électrode de jonction en forme de bande (27bb) s'étendant à partir de la couche d'électrode de jonction enveloppante (27be), dans laquelle, dans une première option, la couche d'électrode de jonction enveloppante (27be) de la première couche d'électrode (27) enveloppe une partie du bord externe de la région spécifique (60), et une couche d'électrode de jonction enveloppante (37be) de la deuxième couche d'électrode (37) enveloppe la partie du bord externe autre que la partie de la région spécifique (60), et la couche d'électrode de jonction en forme de bande (27bb) de la première couche d'électrode (27) et une couche d'électrode de jonction en forme de bande (37bb) de la deuxième couche d'électrode (37) sont adjacentes l'une à l'autre ;
ou, dans une deuxième option, la cellule solaire (1) comprend une pluralité des régions spécifiques (60), et dans laquelle : chacune de la première couche d'électrode (27) et de la deuxième couche d'électrode (37) comporte une ou plusieurs des couches d'électrode de jonction (27b, 37b), la couche d'électrode de jonction (37b) de la deuxième couche d'électrode (37) comporte une couche d'électrode de jonction enveloppante (37be) et une couche d'électrode de jonction en forme de bande (37bb) s'étendant à partir de la couche d'électrode de jonction enveloppante (37be), chaque couche d'électrode de jonction enveloppante (27be) de la première couche d'électrode (27) enveloppe un bord externe d'au moins une région spécifique d'une pluralité des régions spécifiques (60) et chaque couche d'électrode de jonction enveloppante (37be) de la deuxième couche d'électrode (37) enveloppe un bord externe d'au moins une région spécifique de l'autre d'une pluralité des régions spécifiques (60).

2. Cellule solaire (1) selon la revendication 1, comprenant une pluralité des régions spécifiques (60), dans laquelle
la première couche d'électrode (27) comporte une pluralité des couches d'électrode de jonction (27b), et
les couches d'électrode de jonction enveloppantes (27be) d'une pluralité des couches d'électrode de jonction (27b) enveloppent des bords externes d'une pluralité des régions spécifiques (60).

3. Cellule solaire (1) selon la deuxième option de la revendication 1, dans laquelle la couche d'électrode de jonction enveloppante (27be) de la première couche d'électrode (27) est adjacente à la couche d'électrode de jonction enveloppante (37be) de la deuxième couche d'électrode (37).

4. Cellule solaire (1) selon la deuxième option de la revendication 1 ou 2, dans laquelle la couche d'électrode de jonction (37b) de la deuxième couche d'électrode (37) est agencée entre des couches adjacentes parmi les couches d'électrode de jonction (27b) de la première couche d'électrode (27).

5. Cellule solaire (1) selon l'une quelconque des revendications 1 à 4, dans laquelle la couche d'électrode de jonction enveloppante (27be, 37be) a une forme annulaire ou une forme de type anneau ouvert.

6. Cellule solaire (1) selon la revendication 5, dans laquelle la couche d'électrode de jonction enveloppante (27be, 37be) a une forme incurvée.

7. Cellule solaire (1) selon l'une quelconque des revendications 1 à 6, dans laquelle la couche d'électrode de jonction en forme de bande (27bb, 37bb) a une forme incurvée ou une forme linéaire.

8. Cellule solaire (1) selon l'une quelconque des revendications 1 à 7, dans laquelle la couche d'électrode de dérivation (27f, 37f) a une forme incurvée ou une forme linéaire.

9. Cellule solaire (1) selon l'une quelconque des revendications 1 à 8, dans laquelle la région spécifique (60) est un trou traversant ou a un matériau d'une résistance supérieure à la première couche d'électrode (27) et à la deuxième couche d'électrode (37).

10. Cellule solaire (1) selon l'une quelconque des revendications précédentes, dans laquelle une pluralité des régions spécifiques (60) ont la même superficie ou des superficies différentes.

11. Cellule solaire (1) selon la deuxième option de la revendication 1 ou 2, dans laquelle une pluralité des régions spécifiques (60) sont agencées en une ligne.

12. Cellule solaire (1) selon l'une quelconque des revendications 1 à 11, dans laquelle dans une région, à l'exception de la couche d'électrode de jonction (27b, 37b) et de la région spécifique (60), la couche d'électrode de dérivation (27f, 37f) est formée pour être centrée sur le centre du substrat semi-conducteur (11) et pour chevaucher une forme similaire du substrat semi-conducteur (11).

13. Dispositif électronique comprenant la cellule solaire (1) selon l'une quelconque des revendications 1 à 12.
